# EUROPÄISCHE PATENTSCHRIFT

(11) **EP 4 633 427 B1**
(45) Veröffentlichungstag und Bekanntmachung des Hinweises auf die Patenterteilung: **29.07.2026**
(21) Anmeldenummer: 24707654.0
(22) Anmeldetag: 20.02.2024
(51) Int. Cl.: A47B 88/919, A47B 88/40, A47B 21/06

(54) **AUSZIEHELEMENT MIT STROMVERSORGUNGSVORRICHTUNG**
PULL-OUT ELEMENT WITH POWER SUPPLY DEVICE
ÉLÉMENT D'EXTRACTION AVEC DISPOSITIF D'ALIMENTATION ÉLECTRIQUE

(30) Priorität: 24.02.2023 AT 501302023
(43) Veröffentlichungstag der Anmeldung: 22.10.2025
(73) Patentinhaber: JULIUS BLUM GMBH, 6973 Höchst (AT)
(72) Erfinder: ROSSMANN, Maximilian, 88179 Oberreute (DE); PONTNER, Julian, 6971 Hard (AT); MALUCHE, Timo, 6850 Dornbirn (AT); FRITZ, Dominik, 6833 Klaus (AT)
(74) Vertreter: Torggler & Hofmann Patentanwälte - Innsbruck
(86) Internationale Anmeldenummer: PCT/AT2024/060060
(87) Internationale Veröffentlichungsnummer: WO 2024/173969

(56) Entgegenhaltungen:
- WO-A1-2024/044833
- US-A1- 2022 216 012
- NOBGOPODCKII NOBGOPODCKII CTPOITELB: "Kak cppyatatb pozetki: 17 BapiahtoB peshehiya ppoblemy | NoBGopodckii ctpoitelb | Dzeh", 27 March 2020 (2020-03-27), XP093156558, Retrieved from the Internet <URL:https://dzen.ru/a/Xs0-1m72FkFAr0j3> [retrieved on 20240426]

## Beschreibung

Die Erfindung betrifft eine Anordnung gemäß dem Oberbegriff des Anspruchs 1, mit wenigstens einem Ausziehelement, vorzugsweise einer Schublade oder einem Tablar, und wenigstens einer Stromversorgungsvorrichtung. Die Erfindung betrifft weiterhin ein Verfahren zur Montage einer derartigen Anordnung an wenigstens einem Möbelkorpus.

Die WO 2022/051786 A1 offenbart eine Stromversorgungsvorrichtung für Ausziehelemente. Die US 2022/216012 A1 offenbart noch eine Stromversorgungsvorrichtung für Ausziehelemente.

Bei dieser Lösung ist in der Rückwand der Schublade eine Steckdose angeordnet. Dies hat mehrere Nachteile: zunächst ist es erforderlich, dass das Ausziehelement immer eine Rückwand aufweist, was die Bauform des Ausziehelements einschränkt. Weiterhin ist es notwendig, den Strom durch eine technisch aufwändige Umlenkvorrichtung zur Steckdose zu leiten. Gleichzeitig erschwert die Umlenkvorrichtung die Montage der Schublade, da Montageschritte hinter der Rückwand der Schublade notwendig sind. Und schließlich nehmen sowohl die Umlenkvorrichtung als auch die Steckdose Bauraum zwischen der Rückwand der Schublade und einer der Schublade zugewandten Wand des Möbelkorpus in Anspruch, wodurch für die Schublade eine kürzere Nennlänge zur Verfügung steht.

Die Aufgabe der vorliegenden Erfindung besteht darin, die aus dem Stand der Technik bekannten Nachteile zumindest teilweise zu beheben und eine Anordnung mit wenigstens einem Ausziehelement und wenigstens einer gegenüber dem Stand der Technik verbesserten Stromversorgungsvorrichtung, welche insbesondere eine platzsparende und gleichzeitig flexible Bauweise des Ausziehelements ermöglicht und mit einer vereinfachten Montage verbunden ist, anzugeben. Weiterhin soll ein Verfahren zur Montage einer derartigen Anordnung an wenigstens einem Möbelkorpus bereitgestellt werden.

Diese Aufgabe wird durch die Merkmale der Ansprüche 1 und 13 gelöst.

Demnach umfasst die wenigstens eine Stromversorgungsvorrichtung der Anordnung wenigstens eine Haltevorrichtung, welche dazu ausgebildet ist, die Stromentnahmevorrichtung an und/oder in und/oder oberhalb einer Öffnung in einem in Gebrauchslage des Ausziehelements horizontal ausgerichteten Boden des Ausziehelements zu halten.

Dadurch ist es möglich, auf die aus dem Stand der Technik bekannte Umlenkvorrichtung für den Strom zu verzichten und die wenigstens eine Stromentnahmevorrichtung unabhängig von einer Rückwand z.B. im Boden des Ausziehelements und/oder oberhalb des Bodens anzuordnen. Die Bauform des Ausziehelements ist damit praktisch keiner Beschränkung unterworden. Es muss lediglich ein Boden vorgesehen sein.

Weiterhin wird durch die wenigstens eine Haltevorrichtung die Montage des Ausziehelements erleichtert, da es für einen Monteur einfacher ist, Montageschritte oberhalb oder unterhalb des Bodens des Ausziehelements als hinter der Rückwand durchzuführen.

Die erfindungsgemäße Anordnung weist neben der wenigstens einen Stromversorgungsvorrichtung wenigstens ein Ausziehelement, vorzugsweise einer Schublade oder einem Tablar, auf, wobei das Ausziehelement in einer Gebrauchslage, vorzugsweise an einer Längsseite, mit der Ladenschiene der wenigstens einen Ausziehführung verbunden ist, das Ausziehelement wenigstens einen in Gebrauchslage des Ausziehelements horizontal ausgerichteten Boden aufweist, in welchem wenigstens eine, vorzugsweise zylindrische, Öffnung ausgebildet ist, wobei die Stromentnahmevorrichtung mittels der wenigstens einen Haltevorrichtung an und/oder in und/oder oberhalb der Bodenöffnung gehalten ist.

Das erfindungsgemäße Verfahren zur Montage wenigstens einer erfindungsgemäßen Anordnung an wenigstens einem Möbelkorpus umfasst die folgenden, vorzugsweise in der angegeben Reihenfolge chronologischen, Verfahrensschritte: die wenigstens eine Ausziehführung wird über die Korpusschiene am Möbelkorpus montiert, die wenigstens eine Stromentnahmevorrichtung wird mittels der wenigstens einen Haltevorrichtung an und/oder in und/oder oberhalb der Bodenöffnung mit dem Ausziehelement verbunden, und das wenigstens eine Ausziehelement wird mit der Ladenschiene der Ausziehführung verbunden.

Bevorzugte Ausführungsformen sind in den abhängigen Ansprüchen definiert.

Weitere Einzelheiten und Vorteile der Erfindung werden anhand der Figurenbeschreibung unter Bezugnahme auf die Zeichnungen im Folgenden näher erläutert. Darin zeigen:
- Fig. 1, 2: eine Anordnung mit einem Tablar und einer Stromversorgungsvorrichtung in einer perspektivischen Ansicht, wobei in Fig. 2 die Stromentnahmevorrichtung demontiert ist,
- Fig. 3, 4: die in den Fig. 1 und 2 dargestellte Konfiguration ohne Boden (Fig. 3), wobei der Ausschnitt 87 vergrößert dargestellt ist, und von der Unterseite (Fig. 4),
- Fig. 5: die Stromversorgungsvorrichtung in einer Explosionsdarstellung,
- Fig. 6: die gemeinsame Baueinheit aus Kabelführung und Mitnehmer in einer Draufsicht von oben,
- Fig. 7: eine Antriebsvorrichtung in einer stark vereinfachten schematischen Darstellung,
- Fig. 8, 9: ein erstes Ausführungsbeispiel einer Stromleitvorrichtung in einer perspektivischen Ansicht (Fig. 8) und in einer Explosionsansicht (Fig. 9),
- Fig. 10, 11: die Stromleitvorrichtung gemäß dem ersten Ausführungsbeispiel im montierten Zustand an einem Boden mit einer ersten Dicke in einer Querschnittsansicht (Fig. 10) und in einer perspektivischen Ansicht (Fig. 11),
- Fig. 12, 13: die Stromleitvorrichtung gemäß dem ersten Ausführungsbeispiel im montierten Zustand an einem Boden mit einer zweiten Dicke in einer Querschnittsansicht (Fig. 12) und in einer perspektivischen Ansicht (Fig. 13),
- Fig. 14: ein zweites Ausführungsbeispiel einer Anordnung mit einer Schublade und einer Stromversorgungsvorrichtung gemäß einem zweiten Ausführungsbeispiel in einer perspektivischen Ansicht,
- Fig. 15: eine andere Stromleitvorrichtung in einer Explosionsansicht,
- Fig. 16-19: die Stromleitvorrichtung aus Fig. 15 im montierten Zustand an einem Boden mit einer ersten Dicke in einer perspektivischen Ansicht (Fig. 16), ohne Boden (Fig. 17) und in zwei verschiedenen Querschnittsansichten (Fig. 18, 19),
- Fig. 20-23: die Stromleitvorrichtung aus Fig. 15 im montierten Zustand an einem Boden mit einer zweiten Dicke in einer perspektivischen Ansicht (Fig. 20), ohne Boden (Fig. 21) und in zwei verschiedenen Querschnittsansichten (Fig. 22, 23),
- Fig. 24, 25: die Stromleitvorrichtung aus Fig. 15 im montierten Zustand an einem Boden mit einer ersten Dicke (Fig. 24) und mit einer zweiten Dicke (Fig. 25), jeweils in einer weiteren Querschnittsansicht,
- Fig. 26-29: ein weiteres Ausführungsbeispiel einer Stromentnahmevorrichtung in einer perspektivischen Ansicht (Fig. 26) und in Explosionsansichten (Fig. 27-29) aus verschiedenen Blickrichtungen, und
- Fig. 30, 31: ein weiteres Ausführungsbeispiel einer Stromentnahmevorrichtung in einer perspektivischen Ansicht (Fig. 30) und in einer Explosionsansicht (Fig. 31).

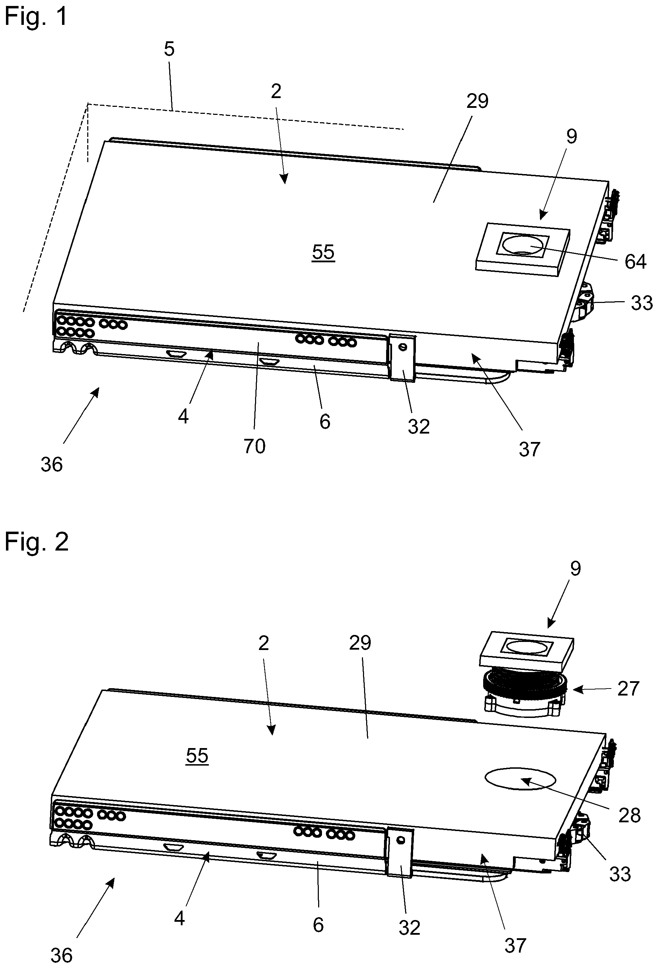

Die Figuren 1 und 2 zeigen eine Anordnung 36 mit wenigstens einem Ausziehelement 2, welches als Tablar ausgebildet ist.

Die Anordnung 36 umfasst wenigstens eine Stromversorgungsvorrichtung 1, wobei Details der Stromversorgungsvorrichtung 1 in den nachfolgenden Figuren 2 bis 6 dargestellt sind.

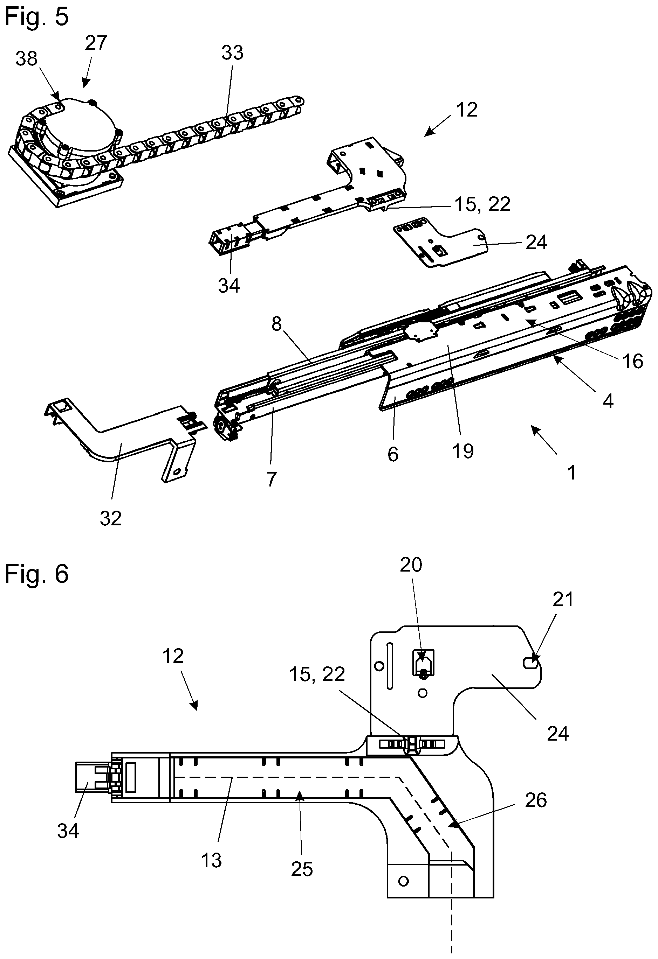

Die Stromversorgungsvorrichtung 1 dient der Stromversorgung des wenigstens einen Ausziehelements 2, vorzugsweise mit 230 V, und umfasst wenigstens eine Ausziehführung 4 zur bewegbaren Lagerung des Ausziehelements 4 an einem Möbelkorpus 5, wobei die Ausziehführung 4 eine am Möbelkorpus 5 zu montierende Korpusschiene 6 und eine mit dem Ausziehelement 2 zu verbindende Ladenschiene 7 aufweist, wobei die Korpusschiene 6 und die Ladenschiene 7 relativ zueinander bewegbar gelagert sind, vorzugsweise wobei zwischen der Korpusschiene 6 und der Ladenschiene 7 wenigstens eine Mittelschiene 8 angeordnet ist (vgl. auch Figur 5).

Das Ausziehelement 2 ist in einer Gebrauchslage, vorzugsweise an einer Längsseite 37, mit der Ladenschiene 7 der wenigstens einen Ausziehführung 4 verbunden. Beim dargestellten Ausführungsbeispiel ist an den beiden gegenüber liegenden Längsseiten 37 des Ausziehelements 2 jeweils eine Ausziehführung 4 angeordnet.

Stromversorgungsvorrichtung 1 umfasst wenigstens eine mit dem Ausziehelement 2 verbundene Stromentnahmevorrichtung 9, vorzugsweise Steckdose. An diese Steckdose können Verbraucher, wie z.B. eine Küchenmaschine, ein Haarfön oder ein Ladekabel angeschlossen werden.

Das Ausziehelement 2 weist wenigstens einen in Gebrauchslage des Ausziehelements 2 horizontal ausgerichteten Boden 29 auf, in welchem wenigstens eine, vorzugsweise zylindrische, Öffnung 28 ausgebildet ist.

Beim dargestellten Ausführungsbeispiel ist die wenigstens eine Stromentnahmevorrichtung 9 zumindest bereichsweise innerhalb der Bodenöffnung 28 angeordnet, d.h. es handelt sich um eine "versenkte Steckdose".

Die Stromentnahmevorrichtung 9 kann wie folgt mit Energie versorgt werden:
Es ist wenigstens eine Stromleitvorrichtung 27 an und/oder in der Bodenöffnung 28 befestigt, um Strom durch die Bodenöffnung 28 zur Stromentnahmevorrichtung 9 zu führen.

Die Stromleitvorrichtung 27 weist wenigstens einen mit einer Unterseite 45 des Bodens 29 des Ausziehelements 2 zu verbindenden Halter 46 und eine in der Bodenöffnung 28 anzuordnende Überbrückungsvorrichtung 48 aufweist, wobei ein Abstand 51 einer Oberseite der Überbrückungsvorrichtung 48 relativ zum Halter 46 einstellbar ist, um die Stromleitvorrichtung 27 an unterschiedlich dicke Böden 29 des Ausziehelements 2, vorzugsweise zwischen 5 mm und 30 mm, anzupassen.

Die Überbrückungsvorrichtung 48 weist wenigstens einen zylindrischen Körper mit einem Außengewinde 53 auf, auf welchem der als Drehteil mit einem Innengewinde ausgebildete Halter 46 verdrehbar gelagert ist.

Es ist wenigstens eine, vorzugsweise mit der Ausziehführung 4 zu verbindende, Kabelführung 12 vorgesehen, welche dazu ausgebildet ist, wenigstens ein Stromkabel 13 zur Stromentnahmevorrichtung 9 zu führen (vgl. auch Fig. 6).

Es bietet sich an, dass die Kabelführung 12 wie im dargestellten Fall, wenigstens eine Rinne 25 umfasst, in welche das wenigstens eine zu führende Stromkabel 13 einlegbar ist, und wenigstens eine Umlenkvorrichtung 26 aufweist, welche das wenigstens eine zu führende Stromkabel 13 um wenigstens 90° umlenkt.

Zwischen der Kabelführung 12 und der Stromleitvorrichtung 27 ist vorteilhafter Weise wenigstens eine Schleppkette 33 angeordnet, welche dazu ausgebildet ist, das wenigstens eine Stromkabel 13 bei einer Bewegung des Ausziehelements 2 zwischen einer Schließstellung und einer Offenstellung in einer Ebene unterhalb des Ausziehelements 2 zu führen. Der Begriff "Schleppkette" ist breit im Sinne einer Energieführung auszulegen, welche flexible Kabel und/oder Leitungen führt und gleichzeitig schützt. Die Schleppkette muss aber nicht zwingend aus Kettengliedern aufgebaut sein.

Die Schleppkette 33 kann an einer Anschlussstelle 38 mit der Stromleitvorrichtung 27 verbunden sein.

Es kann wenigstens eine stationär, vorzugsweise an der Korpusschiene 6, angeordnete Steckvorrichtung 34 vorgesehen sein, über welche die Stromversorgungsvorrichtung 1 mit einer stationären Stromquelle 35 verbindbar ist. Im dargestellten Fall ist die Steckvorrichtung 34 an der Kabelführung 12 angeordnet sein.

Bei der Steckvorrichtung 34 kann es sich um einen länderspezifischen Adapter handeln.

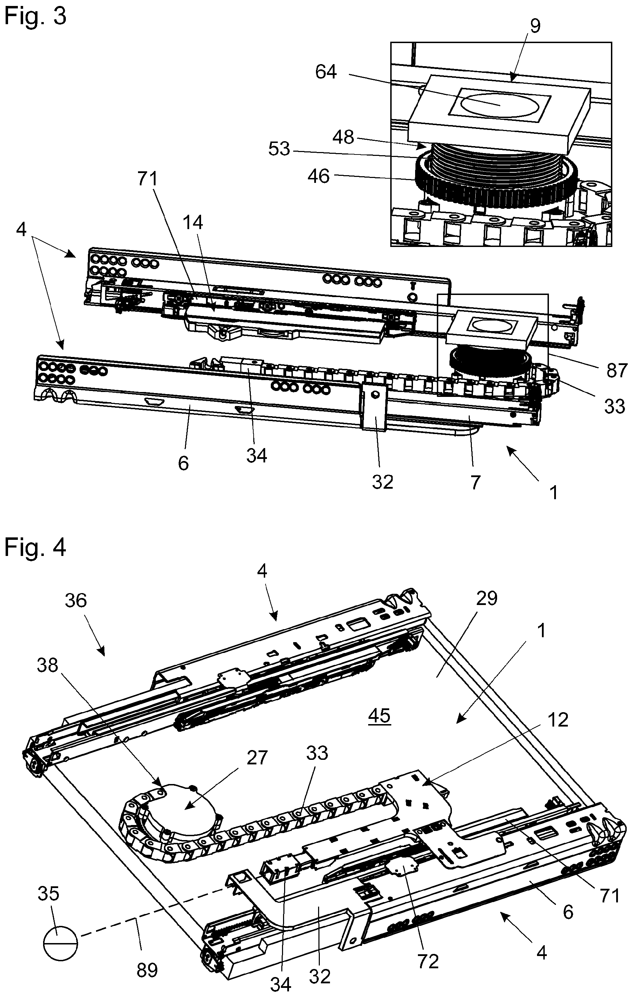

Die Steckvorrichtung 34 und die stationäre Stromquelle 35 sind über wenigstens eine Stromkabel 89 verbindbar, wobei es sich um ein länderspezifisches Kabel handeln kann (vgl. Fig. 4).

Weiterhin kann die Stromversorgungsvorrichtung 1 wenigstens einen Kabelhalter 32 umfassen, welcher lösbar und/oder stirnseitig mit der Korpusschiene 6 verbindbar ist. Hierzu kann z.B. eine Steckverbindung vorgesehen sein.

Alternativ oder ergänzend kann die Stromversorgungsvorrichtung 1 wenigstens eine Abschaltvorrichtung aufweisen, welche wenigstens einen Sensor zur Erfassung einer Schließstellung der Ausziehführung 4 oder des Ausziehelements 2, 3 und wenigstens ein Schaltelement aufweist, mit welchem in Abhängigkeit eines Signals des Sensors die Stromzufuhr unterbrechbar ist.

Vorzugsweise sind die Bestandteile der Stromversorgungsvorrichtung 1 werkzeuglos an der Ausziehführung 4 und/oder am Ausziehelement 2, 3 befestigbar, wodurch eine Nachrüstbarkeit gegeben ist.

Ein weiterer wesentlicher Vorteil der dargestellten Stromversorgungsvorrichtung 1 besteht darin, dass die Bestandteile zum überwiegenden Teil platzsparend unterhalb des Bodens 29 des Ausziehelement 2, 3 angeordnet sind, was eine kostengünstige Bauweise ermöglicht.

Die Kabelführung 12 kann wie folgt an der Ausziehführung 4 befestigbar sein:
Die Stromversorgungsvorrichtung 1 kann wenigstens eine mit der Ausziehführung 4 oder dem Ausziehelement 2, 3 zu verbindende Antriebsvorrichtung 14, mit welcher die Ladenschiene 7 oder das damit zu verbindende Ausziehelement 2, 3 relativ zur Korpusschiene 6 antreibbar ist, und wenigstens einen Mitnehmer 15, welcher über wenigstens eine Schnittstelle 16 lösbar an der Ausziehführung 4 befestigbar und dazu ausgebildet ist, mit der Antriebsvorrichtung 14 zusammenzuwirken, um eine Kraft von der Antriebsvorrichtung 14 auf eine der Schienen der Ausziehführung 4 oder das Ausziehelement 2, 3 zu übertragen, aufweisen, wobei die Kabelführung 12 und der Mitnehmer 15 eine gemeinsame Baueinheit bilden, welche lösbar an der Schnittstelle 16 der Ausziehführung 4 befestigbar ist.

Es bietet sich an, dass die Schnittstelle 16 an einer in Gebrauchslage der Ausziehführung 4 nach unten gewandten Unterseite 19 der Korpusschiene 6 angeordnet ist und/oder wenigstens eine Rastvorrichtung 20 und/oder Einhängevorrichtung 21 aufweist, mit welcher die gemeinsame Baueinheit an der Ausziehführung 4 verrastbar und/oder einhängbar ist.

Bei dem in der Figur 6 dargestellten Ausführungsbeispiel ist sowohl eine Einhängevorrichtung 21, über welche die gemeinsame Baueinheit an der Korpusschiene 6 einhängbar ist, und eine Rastvorrichtung 20, über welche die Baueinheit an der Korpusschiene 6, vorzugsweise im Zuge einer Drehbewegung um eine vertikale Achse, verrastbar ist, vorgesehen.

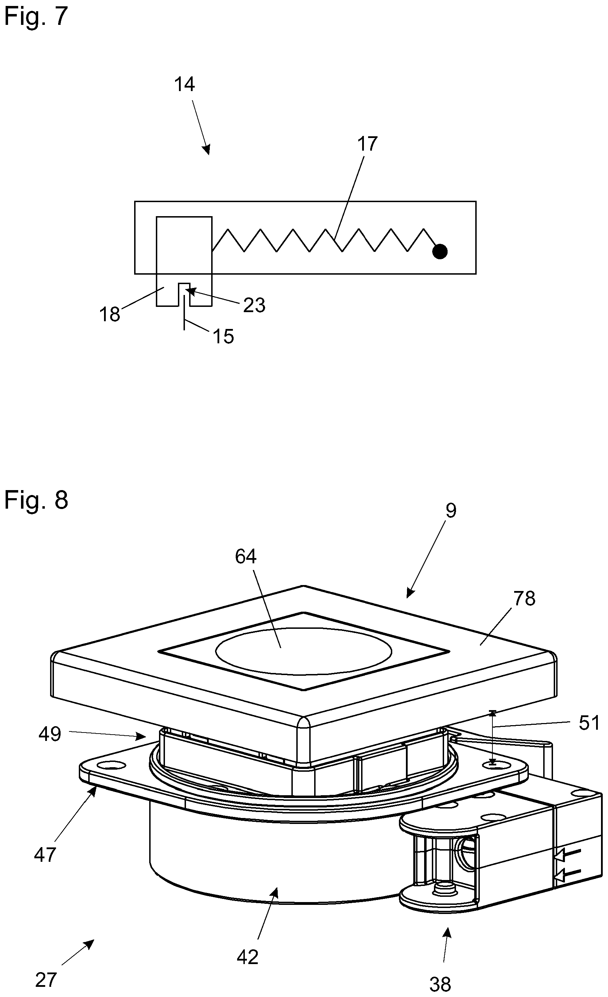

Der Mitnehmer 15 umfasst wenigstens einen abstehenden Zapfen 22 oder Bolzen, welcher in eine Öffnung 23 der Antriebsvorrichtung 14 einführbar ist (vgl. auch Fig. 7).

Die gemeinsame Baueinheit kann ein im Wesentlichen ebenes Halteblech 24 umfassen, welches mit dem Mitnehmer 15, der Kabelführung 12 und/oder der Schnittstelle 16 der Ausziehführung 4 verbindbar oder verbunden ist.

Die Anordnung 36 kann bei diesem und den weiteren dargestellten Ausführungsbeispielen wie folgt an wenigstens einem Möbelkorpus 5 (in der Fig. 1 schematisch angedeutet) montiert werden: die wenigstens eine Ausziehführung 4 wird über die Korpusschiene 6 am Möbelkorpus 5 montiert, vorzugsweise an einem Haltesteg 70 der Korpusschiene 6, die wenigstens eine Stromentnahmevorrichtung 9, 10, 11 wird mit dem Ausziehelement 2, 3 verbunden, und das wenigstens eine Ausziehelement 2, 3 wird mit der Ladenschiene 7 der Ausziehführung 4 verbunden.

Optional können allein oder in einer Kombination die folgenden Verfahrensschritte vorgesehen sein: der wenigstens eine Mitnehmer 15 und die wenigstens eine Kabelführung 12 werden lösbar an der Schnittstelle 16 der Ausziehführung 4 befestigt, die wenigstens eine Antriebsvorrichtung 14 wird mit der Ausziehführung 4 oder dem Ausziehelement 2, 3 verbunden, die wenigstens eine Stromleitvorrichtung 27 wird an und/oder in der Bodenöffnung 28 befestigt, und/oder die wenigstens eine Stromentnahmevorrichtung 9, 10, 11 wird mittels wenigstens einer Haltevorrichtung 30, 31 an und/oder in und/oder oberhalb der Bodenöffnung 28 mit dem Ausziehelement 2, 3 verbunden.

Die Figur 7 zeigt eine Antriebsvorrichtung 14 in einer stark vereinfachten schematischen Darstellung.

Die Antriebsvorrichtung 14 umfasst wenigstens einen Kraftspeicher 17, vorzugsweise wenigstens eine Federvorrichtung, und wenigstens ein damit antreibbares Antriebselement 18, welches mit dem Mitnehmer 15 koppelbar ist.

Die Antriebsvorrichtung 14 kann als Ausstoßvorrichtung ausgebildet sein, um die Ladenschiene 7 oder das damit zu verbindende Ausziehelement 2, 3 relativ zur Korpusschiene 6 aus einer Schließstellung in Richtung einer Offenstellung auszustoßen.

Die Antriebsvorrichtung 14 kann alternativ oder ergänzend als Einzugsvorrichtung 71, welche mit einem Aktuator 72 zusammenwirkt, ausgebildet sein.

Beim in der Figur 3 dargestellten Beispiel sind sowohl eine Ausstoßvorrichtung 14 als auch eine Einzugsvorrichtung 71 vorgesehen. Diese können modular oder in einer gemeinsamen Baueinheit ausgebildet sein.

Die Kabelführung 12 kann mit dem Mitnehmer 15 und/oder mit dem Aktuator 72 eine gemeinsame Baueinheit bilden.

Die Figuren 8 bis 13 zeigen ein ertes Ausführungsbeispiel einer Stromleitvorrichtung 27.

Die Stromleitvorrichtung 27 weist wenigstens eine Anschlussstelle 38 für wenigstens ein Stromkabel 13 und/oder wenigstens eine Schleppkette 33 auf, vorzugsweise wobei die wenigstens die Anschlussstelle 38 wenigstens eine Steckverbindung 39 umfasst und/oder in einer Ebene parallel zum Boden 29 des Ausziehelements 2, 3 angeordnet ist.

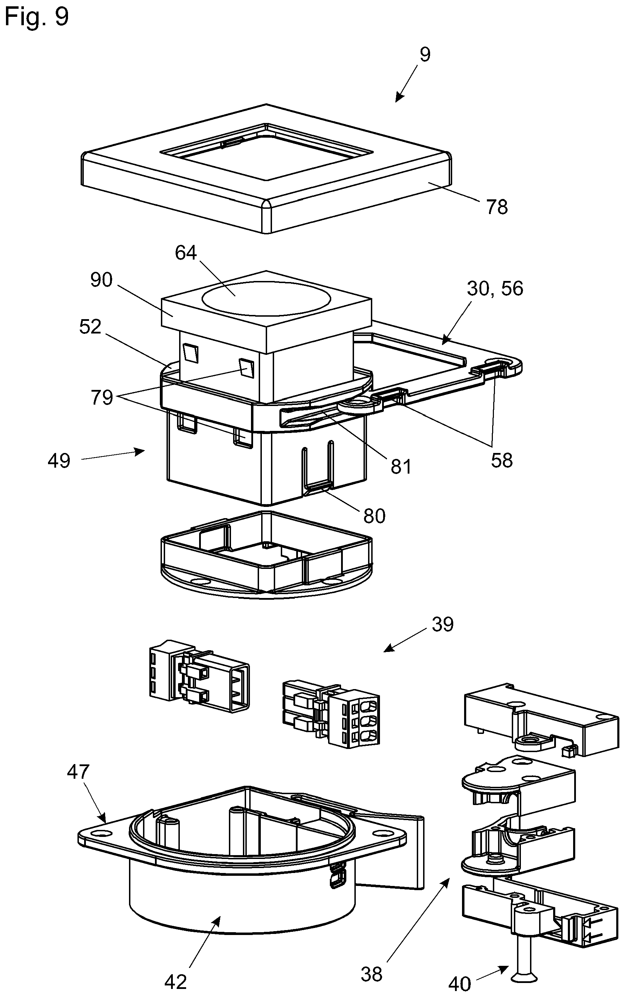

Eine Steckverbindung 39 (vgl. Fig. 9) erleichtert die Montage des Ausziehelements 2, 3, indem hierdurch das Ausziehelement 2 auf die Ladenschiene 7 aufgesetzt und anschließend die Stromleitvorrichtung 27 mit dem Stromkabel 13 und/oder der Schleppkette 33 verbunden werden kann.

Es ist wenigstens eine Einstellvorrichtung 40 vorgesehen, mit welcher eine Lage der Anschlussstelle 38 relativ zu einem Grundkörper 42 der Stromleitvorrichtung 27 und/oder ein Abstand 44 der Anschlussstelle 38 relativ zu einer Unterseite 45 des Bodens 29 des Ausziehelements 2, 3 einstellbar ist.

Das hat den vorteilhaften technischen Effekt, dass die Stromleitvorrichtung 27 auf unterschiedliche Ausziehführungen 4 einstellbar ist. Unterschiedliche Ausziehführungen 4 können sich in ihrer Bauhöhe unterscheiden, insbesondere durch einen Abstand zwischen der Unterseite der Korpusschiene 6 und einem Auflagesteg der Ladenschiene 7.

Beim dargestellten Ausführungsbeispiel umfasst die Einstellvorrichtung 40 eine Stellschraube, mit welcher die Anschlussstelle 38 in vertikaler Richtung gegenüber dem Grundkörper 42 verstellbar ist (vgl. Fig. 9). Zur Erleichterung der Einstellung kann eine Markierung vorgesehen sein, welche z.B. wenigstens zwei Pfeile umfasst.

Es ist wenigstens eine Haltevorrichtung 30 vorgesehen, welche dazu ausgebildet ist, eine Stromentnahmevorrichtung 9 an und in einer Öffnung 28 in einem in Gebrauchslage des Ausziehelements 2, 3 horizontal ausgerichteten Boden 29 des Ausziehelements 2, 3 zu halten.

Die wenigstens eine Haltevorrichtung 30 kann wie im dargestellten Fall an der Stromleitvorrichtung 27 angeordnet oder anordenbar ist, vorzugsweise wobei die Haltevorrichtung 30 verschiebbar an der Stromleitvorrichtung 27 angeordnet ist.

Zur verschiebbaren Lagerung ist kann eine Nut 81 vorgesehen sein.

Die Haltevorrichtung 30 kann die Montage der Stromleitvorrichtung 27 dadurch erleichtern, dass die von oben in die Bodenöffnung 28 eingeführte Stromleitvorrichtung 27 gegen ein weiteres Abrutschen nach unten gesichert wird.

Die Haltevorrichtung 30 umfasst wenigstens einen mit einer Oberseite 55 des Bodens 29 des Ausziehelements 2, 3 zu verbindenden, vorzugsweise zu verschraubenden, Haltebügel.

Erfindungsgemäß ist die Haltevorrichtung 30 zumindest bereichsweise gabelförmig ausgebildet und umgibt die Bodenöffnung 28 in Montagelage zumindest bereichsweise.

Die Stromentnahmevorrichtung 9 kann über wenigstens eine Rastverbindung 58 und/oder wenigstens eine Schraubverbindung 59 mit der Haltevorrichtung 30 verbindbar und/oder auf die Haltevorrichtung 30 aufschiebbar ist.

Beim dargestellten Ausführungsbeispiel ist eine Rastverbindung 58 vorgesehen, welche zwischen einem Rahmen 78 der Stromentnahmevorrichtung 9 und der Haltevorrichtung 30 wirksam ist. Ein zentraler Körper 90, welcher in Montagelage innerhalb des Rahmens 78 angeordnet ist, ist von oben auf die Haltevorrichtung 30 und eine damit verbindbare oder verbundene Überbrückungsvorrichtung 49 aufschiebbar und durch eine Schnappverbindung 79 sicherbar.

Die Stromleitvorrichtung 27 weist wenigstens einen mit einer Unterseite 45 des Bodens 29 des Ausziehelements 2, 3 zu verbindenden, vorzugsweise zu verschraubenden, Halter 47 und eine in der Bodenöffnung 28 anzuordnende Überbrückungsvorrichtung 49 auf, wobei ein Abstand 51 einer Oberseite 52 der Überbrückungsvorrichtung 49 relativ zum Halter 47 einstellbar ist, um die Stromleitvorrichtung 27 an unterschiedlich dicke Böden 29 des Ausziehelements 2, 3, vorzugsweise zwischen 5 mm und 30 mm, anzupassen.

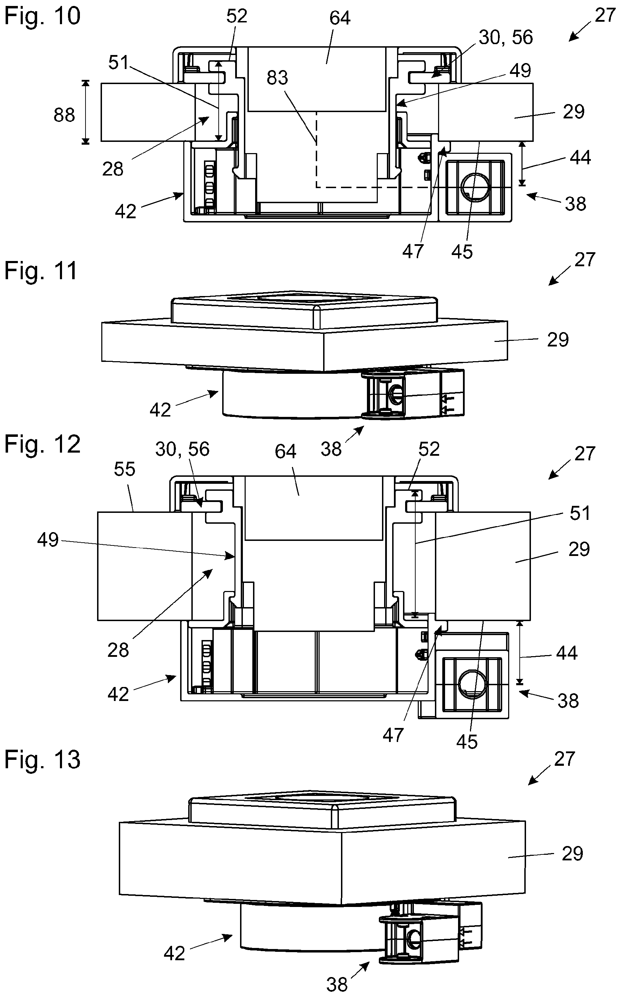

Die Überbrückungsvorrichtung 49 kann verschiebbar im und/oder am Halter 47 gelagert sein. In den Figuren 10 und 12 sind exemplarisch in Abhängigkeit von zwei unterschiedlichen Dicken 88 des Bodens 29 zwei unterschiedliche Stellungen der Überbrückungsvorrichtung 49 relativ zum Halter 47 dargestellt.

Um zu verhindern, dass der Halter 47 oder der Grundkörper 42, an welchem der Halter 47 ausgebildet ist, bei der Montage nach unten abrutscht, kann die Überbrückungsvorrichtung 49 wenigstens eine Rückhaltevorrichtung 80 aufweisen, welche z.B. einen federnden Haken umfasst.

An der Oberseite 52 der Überbrückungsvorrichtung 49 ist ein mit einer Oberseite 55 des Bodens 29 des Ausziehelements 2, 3 zu verbindenden Gegenhalter 56 angeordnet oder anordenbar.

Die Stromleitvorrichtung 27 ist beim dargestellten Ausführungsbeispiel am Boden 29 von unten über den Halter 47 und vom oben über den Gegenhalter 56 gesichert, vorzugsweise verschraubt.

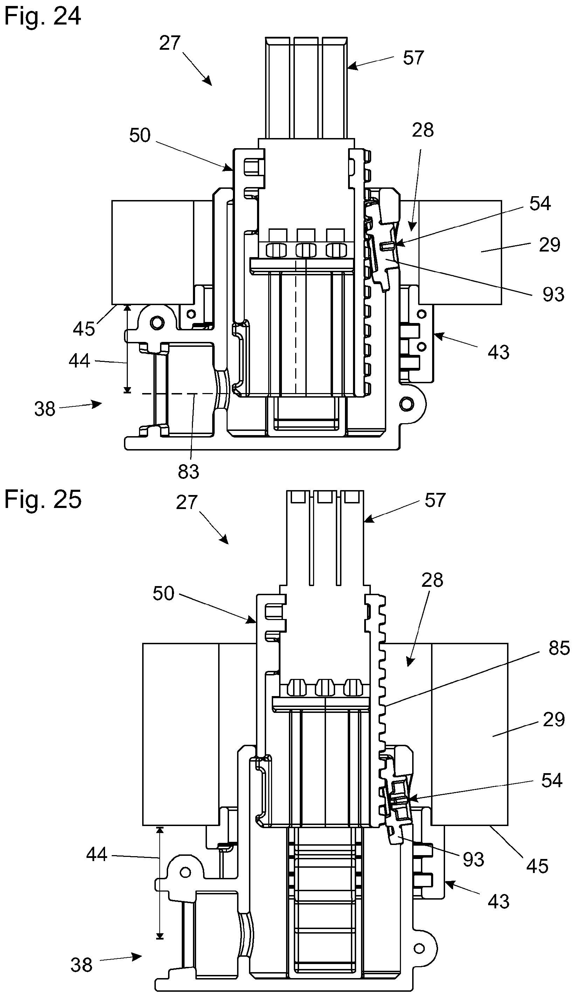

Der Übersichtlichkeit halber sind elektrische Verkabelungen in den Figuren nicht dargestellt. Stellvertretend ist in den Figuren 10 und 24 ein Stromleiter 83 angedeutet, welcher die Anschlussstelle 38 elektrisch leitend mit der Stromentnahmevorrichtung 9 oder einer Steckvorrichtung 57 verbindet.

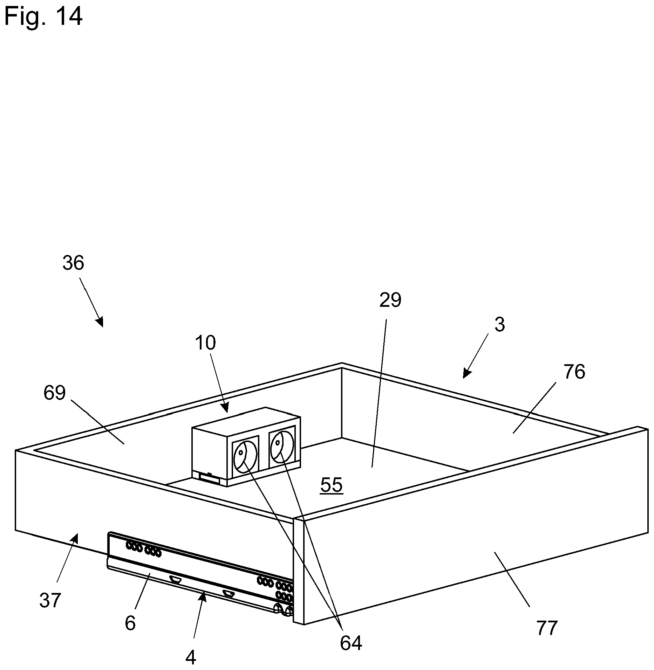

Die Figur 14 zeigt ein weiteres Ausführungsbeispiel einer Anordnung 36 mit einem als Schublade ausgebildeten Ausziehelement 3 und einer Stromversorgungsvorrichtung 1 gemäß einem weiteren Ausführungsbeispiel.

Das Ausziehelement 3 ist in einer Gebrauchslage, vorzugsweise an einer Längsseite 37, mit der Ladenschiene 7 der wenigstens einen Ausziehführung 4 verbunden.

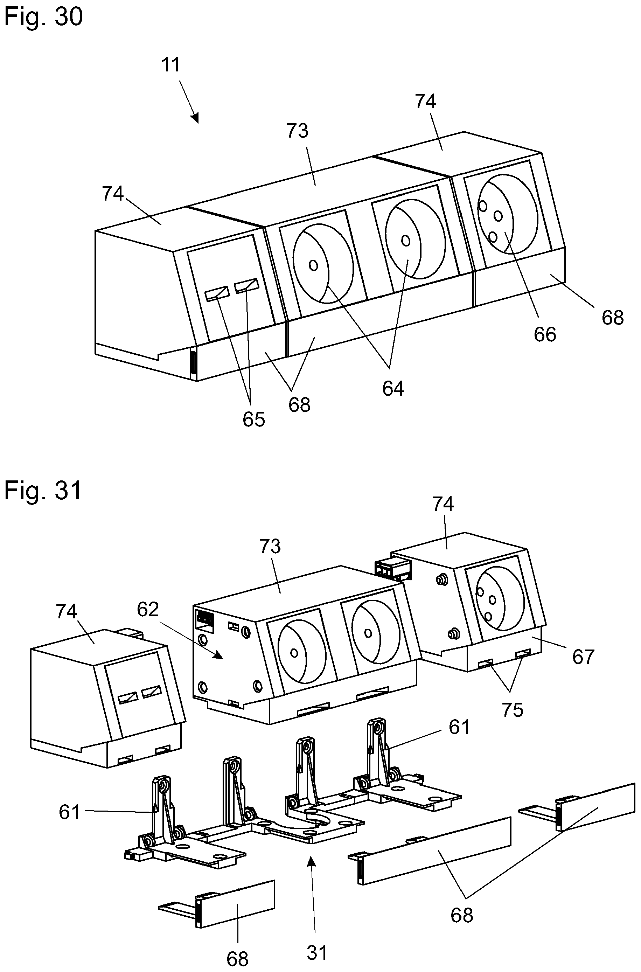

Das Ausziehelement 3 weist wenigstens eine im Wesentlichen vertikal zum Boden 29 ausgerichtete Rückwand 69 auf. Wenigstens eine Stromentnahmevorrichtung 10 oder 11 (vgl. Fig. 30, 31) ist oberhalb der Bodenöffnung 28, in einer Ebene parallel zur Rückwand 69 und außerhalb der Rückwand 69 angeordnet.

Alternativ oder ergänzend kann das Ausziehelement 3 auch eine im Boden 29 versenkte Stromentnahmevorrichtung 9 aufweisen, wie sie z.B. in den vorhergehenden Figuren dargestellt ist.

Das Ausziehelement 3 kann zwei gegenüberliegende Seitenwände 76 und eine Frontwand 77 aufweisen.

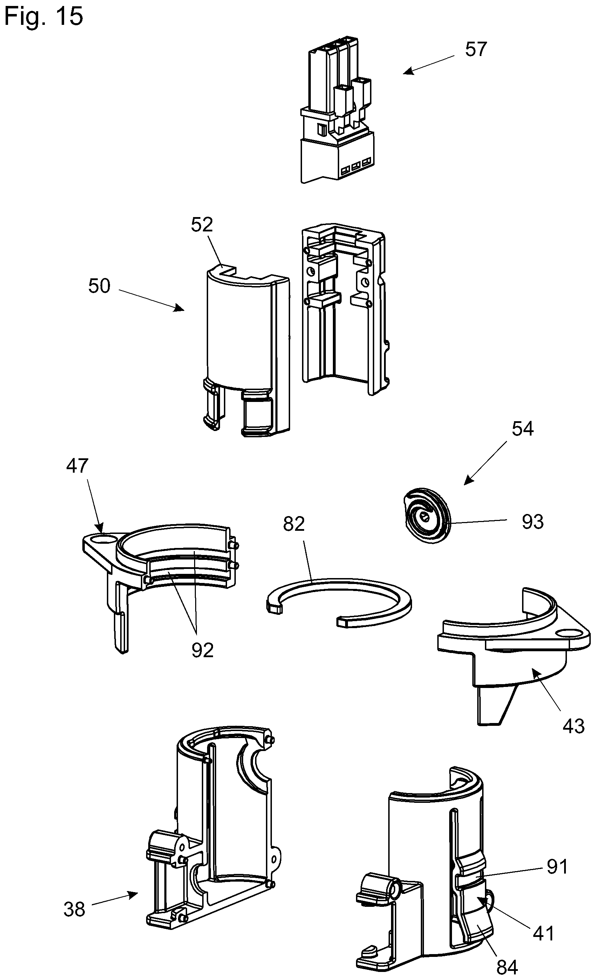

In den Figuren 15 bis 25 ist eine weitere Stromleitvorrichtung 27 dargestellt.

Die Stromleitvorrichtung 27 weist wenigstens eine Anschlussstelle 38 für wenigstens ein Stromkabel 13 und/oder wenigstens eine Schleppkette 33 auf, vorzugsweise wobei die wenigstens die Anschlussstelle 38 wenigstens eine Steckverbindung 39 umfasst und/oder in einer Ebene parallel zum Boden 29 des Ausziehelements 2, 3 angeordnet ist.

Es ist wenigstens eine Einstellvorrichtung 41 vorgesehen, mit welcher eine Lage der Anschlussstelle 38 relativ zu einem Grundkörper 43 der Stromleitvorrichtung 27 und/oder ein Abstand 44 der Anschlussstelle 38 relativ zu einer Unterseite 45 des Bodens 29 des Ausziehelements 2, 3 einstellbar ist.

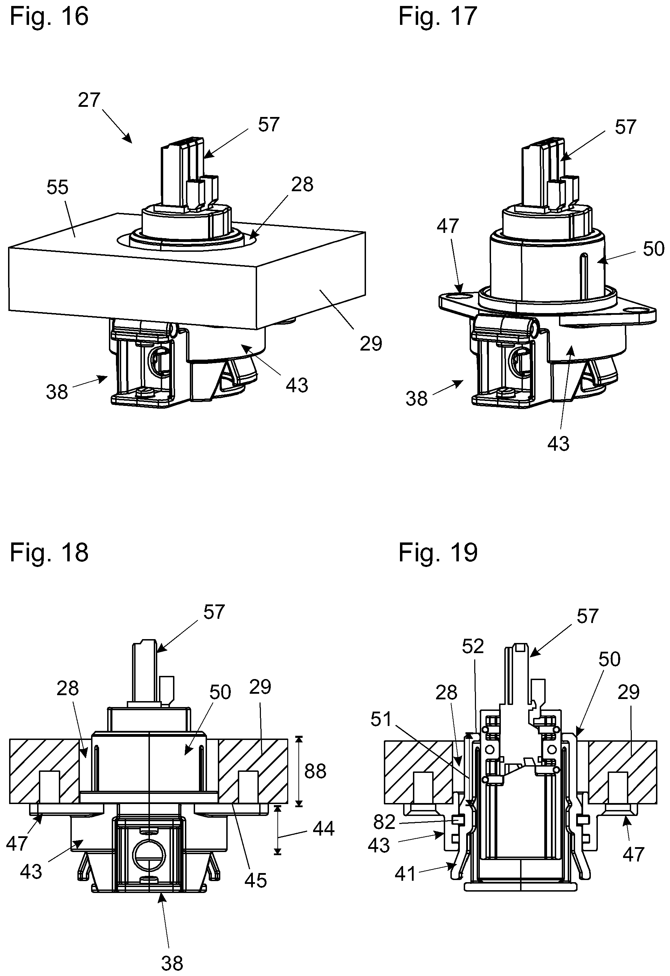

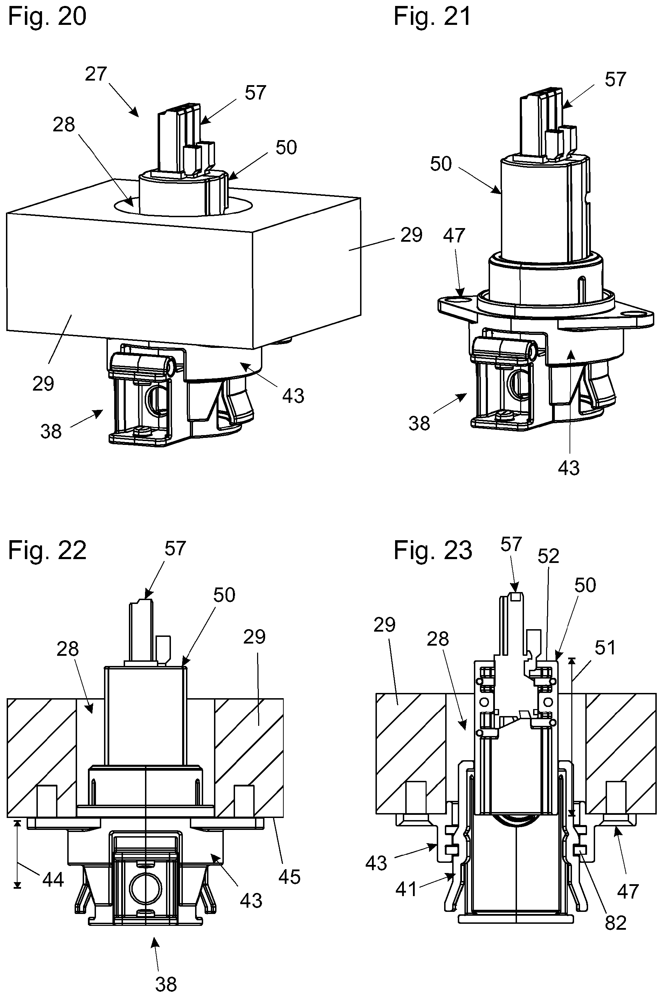

Die Einstellvorrichtung 41 kann wie im dargestellten Fall ein an einem, vorzugsweise federnden, Betätigungshebel 84 in einer Nut 91 gelagertes Rastelement 82 aufweisen, welches in korrespondierende Ausnehmungen 92 einrastbar ist (vgl. Fig. 19 und 23).

Die Stromleitvorrichtung 27 weist wenigstens einen mit einer Unterseite 45 des Bodens 29 des Ausziehelements 2, 3 zu verbindenden, vorzugsweise zu verschraubenden, Halter 47 und eine in der Bodenöffnung 28 anzuordnende Überbrückungsvorrichtung 50 auf, wobei ein Abstand 51 einer Oberseite 52 der Überbrückungsvorrichtung 50 relativ zum Halter 47 einstellbar ist, um die Stromleitvorrichtung 27 an unterschiedlich dicke Böden 29 des Ausziehelements 2, 3, vorzugsweise zwischen 5 mm und 30 mm, anzupassen.

Es ist wenigstens eine Einstellvorrichtung 54 vorgesehen, mit welcher eine Lage der Überbrückungsvorrichtung 50 relativ zum Halter 47 einstellbar ist. Die Einstellvorrichtung 54 kann z.B. ein drehbar gelagertes Schneckenrad 93 umfassen, welches mit einer Verzahnung 85 zusammenwirkt (vgl. Fig. 24 und 25).

Die Stromleitvorrichtung 27 weist wenigstens eine Steckvorrichtung 57 auf, über welche die Stromentnahmevorrichtung 10, 11 in elektrisch leitenden Kontakt mit der Stromleitvorrichtung 27 bringbar ist, vorzugsweise wobei die Steckvorrichtung 57 in Montagelage der Stromleitvorrichtung 27 über die Oberseite 55 des Bodens 29 des Ausziehelement 2, 3 aus der Bodenöffnung 28 hervorsteht.

Die wenigstens eine Steckvorrichtung 57 erleichtert die Montage und das Abnehmen des Ausziehelement 2, 3.

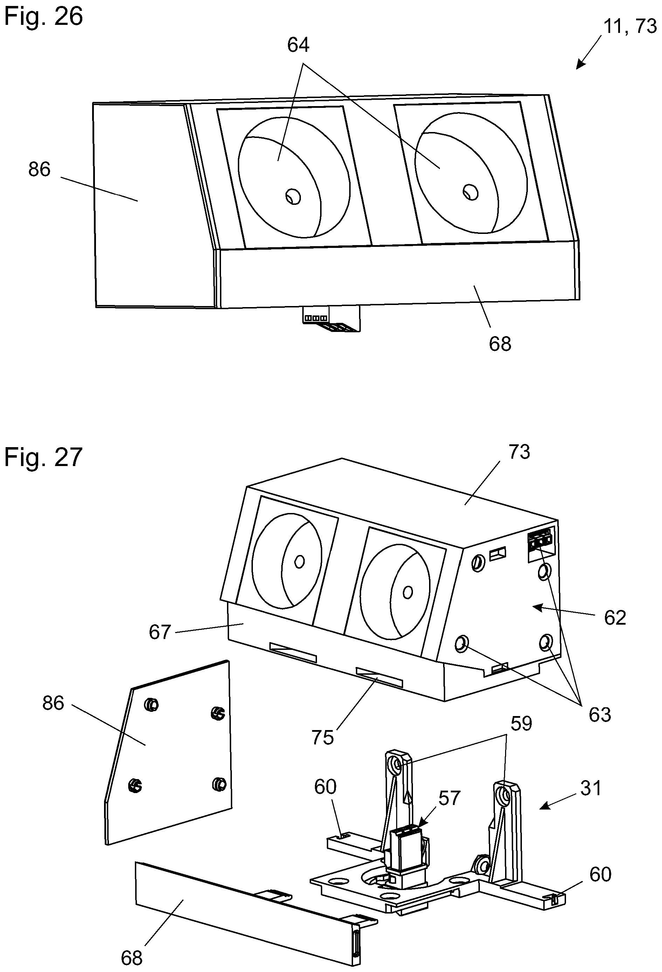

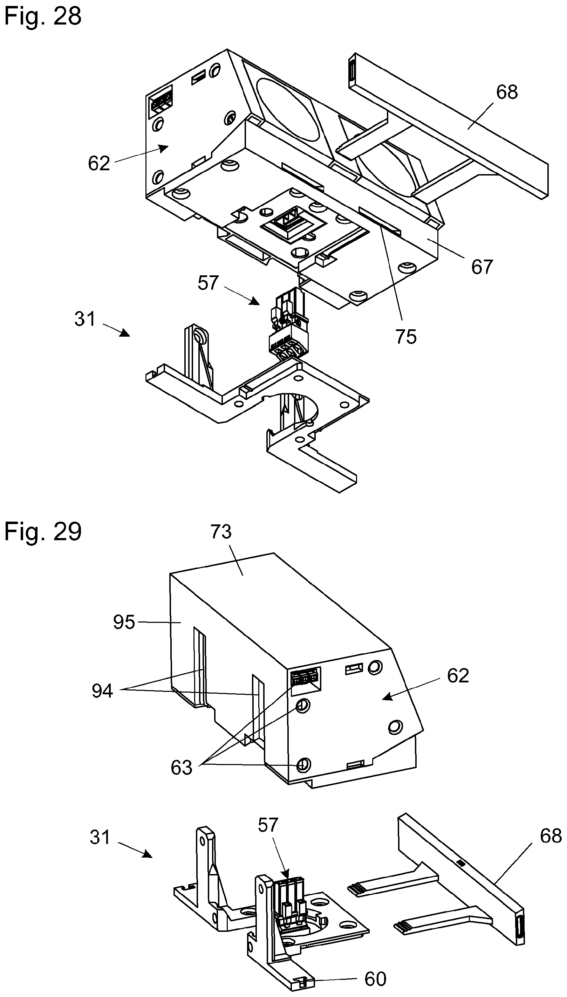

Die Figuren 26 bis 29 und Fig. 30 sowie 31 zeigen weitere Ausführungsbeispiele einer Stromentnahmevorrichtung 11.

Es ist wenigstens eine Haltevorrichtung 31 vorgesehen, welche dazu ausgebildet ist, die Stromentnahmevorrichtung 11 an und oberhalb einer Öffnung 28 in einem in Gebrauchslage des Ausziehelements 2, 3 horizontal ausgerichteten Boden 29 des Ausziehelements 2, 3 zu halten.

Die Haltevorrichtung 31 umfasst wenigstens einen mit einer Oberseite 55 des Bodens 29 des Ausziehelements 2, 3 zu verbindenden, vorzugsweise verschraubbaren, Haltebügel.

Erfindungsgemäß ist die Haltevorrichtung 31 zumindest bereichsweise gabelförmig ausgebildet und umgibt die Bodenöffnung 28 in Montagelage zumindest bereichsweise.

Die Stromentnahmevorrichtung 11 ist über wenigstens eine Schraubverbindung 59 mit der Haltevorrichtung 31 verbindbar und auf die Haltevorrichtung 31 aufschiebbar. Hierzu sind an der Stromentnahmevorrichtung 11, vorzugsweise an einer Rückseite 95, Führungen 94 angeordnet.

Die Haltevorrichtung 31 weist wenigstens eine Schnittstelle 60 zur Verbindung mit wenigstens einer weiteren Haltevorrichtung 61 für eine wenigstens eine weitere Stromentnahmevorrichtung auf.

Die Stromentnahmevorrichtung 11 weist wenigstens eine, vorzugsweise an einer Seitenfläche 62 angeordnete, Schnittstelle 63 zur Anbindung wenigstens einer weiteren Stromentnahmevorrichtung auf, vorzugsweise wobei sich die Stromentnahmevorrichtungen durch eine Form einer Stromsteckeraufnahme 64, 65, 66 voneinander unterscheiden (vgl. Fig. 30). Z.B. kann es sich um eine USB-Steckeraufnahme oder eine im deutschsprachigen Raum gebräuchliche 230V-Steckeraufnahme handeln.

Beim Ausführungsbeispiel gemäß den Figuren 30, 31 ist ein zentrales Grundmodul 73 vorgesehen, an welches seitlich Zusatzmodule 74 angebracht sind.

Die Schnittstelle 63 kann durch eine Abdeckung 86 abgedeckt sein.

Die Stromentnahmevorrichtung 11 kann wenigstens eine, vorzugsweise in der Nähe des Bodens 29 des Ausziehelements 2, 3 und/oder an einer Stirnseite 67 angeordnete, Schnittstelle 75 zur Montage einer Logoplatte 68 aufweisen.

## Patentansprüche

1. Anordnung (36) mit wenigstens einem Ausziehelement (2, 3), vorzugsweise einer Schublade oder einem Tablar, und wenigstens einer Stromversorgungsvorrichtung (1) zur Stromversorgung des wenigstens einen Ausziehelements (2, 3), wobei die wenigstens eine Stromversorgungsvorrichtung umfasst
- wenigstens eine Ausziehführung (4) zur bewegbaren Lagerung des Ausziehelements (2, 3) an einem Möbelkorpus (5), wobei die Ausziehführung (4) eine am Möbelkorpus (5) zu montierende Korpusschiene (6) und eine mit dem Ausziehelement (2, 3) zu verbindende Ladenschiene (7) aufweist, wobei die Korpusschiene (6) und die Ladenschiene (7) relativ zueinander bewegbar gelagert sind, vorzugsweise wobei zwischen der Korpusschiene (6) und der Ladenschiene (7) wenigstens eine Mittelschiene (8) angeordnet ist,
- wenigstens eine mit dem Ausziehelement (2, 3) zu verbindende Stromentnahmevorrichtung (9, 10, 11), vorzugsweise Steckdose, und
- wenigstens eine, vorzugsweise mit der Ausziehführung (4) zu verbindende, Kabelführung (12), welche dazu ausgebildet ist, wenigstens ein Stromkabel (13) zur Stromentnahmevorrichtung (9, 10, 11) zu führen,
**dadurch gekennzeichnet, dass** wenigstens eine Haltevorrichtung (30, 31) vorgesehen ist, welche dazu ausgebildet ist, die Stromentnahmevorrichtung (9, 10, 11) an und/oder in und/oder oberhalb einer Öffnung (28) in einem in Gebrauchslage des Ausziehelements (2, 3) horizontal ausgerichteten Boden (29) des Ausziehelements (2, 3) zu halten, wobei das Ausziehelement (2, 3) in einer Gebrauchslage, vorzugsweise an einer Längsseite (37), mit der Ladenschiene (7) der wenigstens einen Ausziehführung (4) verbunden ist, wobei das Ausziehelement (2, 3) wenigstens einen in Gebrauchslage des Ausziehelements (2, 3) horizontal ausgerichteten Boden (29) aufweist, in welchem wenigstens eine, vorzugsweise zylindrische, Öffnung (28) ausgebildet ist, wobei die Stromentnahmevorrichtung (9, 10, 11) mittels der wenigstens einen Haltevorrichtung (30, 31) an und/oder in und/oder oberhalb der Bodenöffnung (28) gehalten ist, wobei die Haltevorrichtung (30, 31) zumindest bereichsweise gabelförmig ausgebildet ist und die Bodenöffnung (28) in Montagelage zumindest bereichsweise umgibt.

2. Anordnung (36) nach Anspruch 1, wobei die Haltevorrichtung (30, 31) wenigstens einen mit einer Oberseite (55) des Bodens (29) des Ausziehelements (2, 3) zu verbindenden, vorzugsweise verschraubbaren, Haltebügel umfasst.

3. Anordnung (36) nach einem der Ansprüche 1 bis 2, wobei die Stromentnahmevorrichtung (9, 10, 11) über wenigstens eine Rastverbindung (58) und/oder wenigstens eine Schraubverbindung (59) mit der Haltevorrichtung (30, 31) verbindbar und/oder auf die Haltevorrichtung (30, 31) aufschiebbar ist.

4. Anordnung (36) nach einem der Ansprüche 1 bis 3, wobei die Haltevorrichtung (31) wenigstens eine Schnittstelle (60) zur Verbindung mit wenigstens einer weiteren Haltevorrichtung (61) für eine wenigstens eine weitere Stromentnahmevorrichtung (9, 10, 11) aufweist.

5. Anordnung (36) nach einem der Ansprüche 1 bis 4, wobei die Stromentnahmevorrichtung (9, 10, 11) wenigstens eine, vorzugsweise an einer Seitenfläche (62) angeordnete, Schnittstelle (63) zur Anbindung wenigstens einer weiteren Stromentnahmevorrichtung (9, 10, 11) aufweist, vorzugsweise wobei sich die Stromentnahmevorrichtung (9, 10, 11) und die wenigstens eine weitere Stromentnahmevorrichtung (9, 10, 11) durch eine Form einer Stromsteckeraufnahme (64, 65, 66) voneinander unterscheiden.

6. Anordnung (36) nach einem der Ansprüche 1 bis 5, wobei die Stromentnahmevorrichtung (9, 10, 11) wenigstens eine, vorzugsweise in der Nähe des Bodens (29) des Ausziehelements (2, 3) und/oder an einer Stirnseite (67) angeordnete, Schnittstelle (75) zur Montage einer Logoplatte (68) aufweist.

7. Anordnung (36) nach einem der Ansprüche 1 bis 6, wobei die Ausziehführung (4) oder das Ausziehelement (2, 3) mit wenigstens einer Antriebsvorrichtung (14), mit welcher die Ladenschiene (7) oder das damit zu verbindende Ausziehelement (2, 3) relativ zur Korpusschiene (6) antreibbar ist, verbindbar oder verbunden ist, und die Stromversorgungsvorrichtung (1) wenigstens einen Mitnehmer (15), welcher über wenigstens eine Schnittstelle (16) lösbar an der Ausziehführung (4) befestigbar und dazu ausgebildet ist, mit der Antriebsvorrichtung (14) zusammenzuwirken, um eine Kraft von der Antriebsvorrichtung (14) auf eine der Schienen der Ausziehführung (4) oder das Ausziehelement (2, 3) zu übertragen, umfasst, wobei die Kabelführung (12) und der Mitnehmer (15) eine gemeinsame Baueinheit bilden, welche lösbar an der Ausziehführung (4) befestigbar ist.

8. Anordnung (36) nach einem der Ansprüche 1 bis 7, wobei wenigstens eine Stromleitvorrichtung (27) vorgesehen ist, welche dazu ausgebildet ist, an und/oder in einer Öffnung (28) in einem in Gebrauchslage des Ausziehelements (2, 3) horizontal ausgerichteten Boden (29) des Ausziehelements (2, 3) befestigt zu werden und Strom durch die Bodenöffnung (28) zur Stromentnahmevorrichtung (9, 10, 11) zu führen.

9. Anordnung (36) nach Anspruch 8, wobei die wenigstens eine Haltevorrichtung (30) an der Stromleitvorrichtung (27) angeordnet oder anordenbar ist, vorzugsweise wobei die Haltevorrichtung (30) verschiebbar an der Stromleitvorrichtung (27) angeordnet ist.

10. Anordnung (36) nach Anspruch 8 oder 9, wobei die Stromleitvorrichtung (27) wenigstens eine Steckvorrichtung (57) aufweist, über welche die Stromentnahmevorrichtung (9, 10, 11) in elektrisch leitenden Kontakt mit der Stromleitvorrichtung (27) bringbar ist, vorzugsweise wobei die Steckvorrichtung (57) in Montagelage der Stromleitvorrichtung (27) über die Oberseite (55) des Bodens (29) des Ausziehelement (2, 3) aus der Bodenöffnung (28) hervorsteht.

11. Anordnung (36) nach einem der Ansprüche 1 bis 10, wobei die Stromversorgungsvorrichtung (1) weiter umfasst
- wenigstens einen Kabelhalter (32), welcher lösbar und/oder stirnseitig mit der Korpusschiene (6) verbindbar ist, und/oder
- wenigstens eine Schleppkette (33), welche dazu ausgebildet ist, das wenigstens eine Stromkabel (13) bei einer Bewegung des Ausziehelements (2, 3) zwischen einer Schließstellung und einer Offenstellung in einer Ebene unterhalb des Ausziehelements (2, 3) zu führen, und/oder
- wenigstens eine stationär, vorzugsweise an der Korpusschiene (6), angeordnete Steckvorrichtung (34), über welche die Stromversorgungsvorrichtung (1) mit einer stationären Stromquelle (35) verbindbar ist, und/oder
- wenigstens eine Abschaltvorrichtung, welche wenigstens einen Sensor zur Erfassung einer Schließstellung der Ausziehführung (4) oder des Ausziehelements (2, 3) und wenigstens ein Schaltelement aufweist, mit welchem in Abhängigkeit eines Signals des Sensors die Stromzufuhr unterbrechbar ist.

12. Anordnung (36) nach einem der Ansprüche 1 bis 11, wobei die wenigstens eine Stromentnahmevorrichtung (9, 10, 11) zumindest bereichsweise innerhalb der Bodenöffnung (28) angeordnet ist oder das Ausziehelement (2, 3) wenigstens eine im Wesentlichen vertikal zum Boden (29) ausgerichtete Rückwand (69) aufweist und die wenigstens eine Stromentnahmevorrichtung (9, 10, 11) oberhalb der Bodenöffnung (28), in einer Ebene parallel zur Rückwand (69) und außerhalb der Rückwand (69) angeordnet ist.

13. Verfahren zur Montage wenigstens einer Anordnung (36) nach einem der Ansprüche 1 bis 12, an wenigstens einem Möbelkorpus (5), wobei das Verfahren die folgenden, vorzugsweise in der angegeben Reihenfolge chronologischen, Verfahrensschritte umfasst:
- die wenigstens eine Ausziehführung (4) wird über die Korpusschiene (6) am Möbelkorpus (5) montiert,
- die wenigstens eine Stromentnahmevorrichtung (9, 10, 11) wird mittels der wenigstens einen Haltevorrichtung (30, 31) an und/oder in und/oder oberhalb der Bodenöffnung (28) mit dem Ausziehelement (2, 3) verbunden, und
- das wenigstens eine Ausziehelement (2, 3) wird mit der Ladenschiene (7) der Ausziehführung (4) verbunden.

## Claims

1. An arrangement (36) with at least one pull-out element (2, 3), preferably a drawer or a tray, and at least one power supply device (1) for supplying power to at least one pull-out element (2, 3), wherein the at least one power supply device comprises
- at least one pull-out guide (4) for the movable mounting of the pull-out element (2, 3) on a furniture body (5), wherein the pull-out guide (4) has a body rail (6) to be mounted on the furniture body (5) and a drawer rail (7) to be connected to the pull-out element (2, 3), wherein the body rail (6) and the drawer rail (7) are mounted so as to be movable relative to one another, preferably wherein at least one central rail (8) is arranged between the body rail (6) and the drawer rail (7),
- at least one power outlet device (9, 10, 11), preferably a socket, to be connected to the pull-out element (2, 3), and
- at least one cable guide (12), which is preferably to be connected to the pull-out guide (4) and is designed to guide at least one power cable (13) to the power outlet device (9, 10, 11),
**characterized in that** at least one holding device (30, 31) is provided, which is designed to hold a power outlet device (9, 10, 11) on and/or in and/or above an opening (28) in a base (29) of the pull-out element (2, 3), which is horizontally aligned in the position of use of the pull-out element (2, 3), wherein the pull-out element (2, 3) is connected in a position of use, preferably on a longitudinal side (37), to the drawer rail (7) of the at least one pull-out guide (4), wherein the pull-out element (2, 3) has at least one base (29) which is aligned horizontally in the position of use of the pull-out element (2, 3) and in which at least one, preferably cylindrical, opening (28) is formed, wherein the power outlet device (9, 10, 11) is held on and/or in and/or above the base opening (28) by means of the at least one holding device (30, 31), wherein the holding device (30, 31) is fork-shaped at least in some regions and surrounds the base opening (28) in the mounted position at least in some regions.

2. The arrangement (36) according to claim 1, wherein the holding device (30, 31) comprises at least one holding bracket to be connected, preferably screwable, to an upper side (55) of the base (29) of the pull-out element (2, 3).

3. The arrangement (36) according to one of claims 1 to 2, wherein the power outlet device (9, 10, 11) can be connected to the holding device (30, 31) and/or pushed onto the holding device (30, 31) via at least one latching connection (58) and/or at least one screw connection (59).

4. The arrangement (36) according to one of claims 1 to 3, wherein the holding device (31) has at least one interface (60) for connection to at least one further holding device (61) for at least one further power outlet device (9, 10, 11).

5. The arrangement (36) according to one of claims 1 to 4, wherein the power outlet device (9, 10, 11) has at least one interface (63), preferably arranged on a side surface (62), for connecting at least one further power outlet device (9, 10, 11), preferably wherein the power outlet device (9, 10, 11) and the at least one further power outlet device (9, 10, 11) differ from one another by the shape of a power plug receptacle (64, 65, 66).

6. The arrangement (36) according to one of claims 1 to 5, wherein the power outlet device (9, 10, 11) has at least one interface (75) for mounting a logo plate (68), preferably arranged near the base (29) of the pull-out element (2, 3) and/or on an end face (67).

7. The arrangement (36) according to one of claims 1 to 6, wherein the pull-out guide (4) or the pull-out element (2, 3) can be connected or is connected to at least one drive device (14), with which the drawer rail (7) or the pull-out element (2, 3) to be connected thereto can be driven relative to the body rail (6), and the power supply device (1) has at least one driver (15), which can be detachably fastened to the pull-out guide (4) via at least one interface (16) and is designed to cooperate with the drive device (14) in order to transmit a force from the drive device (14) to one of the rails of the pull-out guide (4) or the pull-out element (2, 3), wherein the cable guide (12) and the driver (15) form a common structural unit which can be detachably fastened to the pull-out guide (4) .

8. The arrangement (36) according to one of claims 1 to 7, wherein at least one current conducting device (27) is provided, which is designed to be fastened to and/or in an opening (28) in a base (29) of the pull-out element (2, 3) which is horizontally aligned in the position of use of the pull-out element (2, 3) and to conduct current through the base opening (28) to the power outlet device (9, 10, 11).

9. The arrangement (36) according to claim 8, wherein the at least one holding device (30) is arranged or can be arranged on the current conducting device (27), preferably wherein the holding device (30) is arranged displaceably on the current conducting device (27).

10. The arrangement (36) according to claim 8 or 9, wherein the current conducting device (27) has at least one plug-in device (57), via which the power outlet device (9, 10, 11) can be brought into electrically conductive contact with the current conducting device (27), preferably wherein the plug-in device (57) projects out of the base opening (28) via the upper side (55) of the base (29) of the pull-out element (2, 3) in the mounting position of the current conducting device (27).

11. The arrangement (36) according to one of claims 1 to 10, wherein the power supply device (1) further comprises
- at least one cable holder (32) which can be detachably and/or frontally connected to the body rail (6), and/or
- at least one drag chain (33) which is designed to guide the at least one power cable (13) during a movement of the pull-out element (2, 3) between a closed position and an open position in a plane below the pull-out element (2, 3), and/or
- at least one stationary plug-in device (34), preferably arranged on the body rail (6), via which the power supply device (1) can be connected to a stationary power source (35), and/or
- at least one switch-off device, which has at least one sensor for detecting a closed position of the pull-out guide (4) or of the pull-out element (2, 3) and at least one switching element, with which the power supply can be interrupted as a function of a signal from the sensor.

12. The arrangement (36) according to one of claims 1 to 11, wherein the at least one power outlet device (9, 10, 11) is arranged at least in regions within the base opening (28) or the pull-out element (2, 3) has at least one rear wall (69) aligned substantially vertically to the base (29) and the at least one power outlet device (9, 10, 11) is arranged above the base opening (28), in a plane parallel to the rear wall (69) and outside the rear wall (69).

13. A method for mounting at least one arrangement (36) according to one of claims 1 or 12, on at least one furniture body (5), wherein the method comprises the following method steps, preferably in the specified chronological order:
- the at least one pull-out guide (4) is mounted on the furniture body (5) via the body rail (6),
- the at least one power outlet device (9, 10, 11) is connected to the pull-out element (2, 3) by means of the at least one holding device (30, 31) on and/or in and/or above the base opening (28), and
- the at least one pull-out element (2, 3) is connected to the drawer rail (7) of the pull-out guide (4).

## Revendications

1. Arrangement (36) comprenant au moins un élément extractible (2, 3), de préférence un tiroir ou une tablette, et au moins un dispositif d'alimentation électrique (1) pour alimenter électriquement ledit au moins un élément extractible (2, 3), ledit au moins un dispositif d'alimentation électrique comprenant
- au moins une glissière d'extraction (4) pour le montage mobile de l'élément extractible (2, 3) sur un corps de meuble (5), la glissière d'extraction (4) présentant un rail de corps (6) à monter sur le corps de meuble (5) et un rail de tiroir (7) à relier à l'élément extractible (2, 3), le rail de corps (6) et le rail de tiroir (7) étant montés mobiles l'un par rapport à l'autre, au moins un rail intermédiaire (8) étant de préférence disposé entre le rail de corps (6) et le rail de tiroir (7),
- au moins un dispositif de prélèvement de courant (9, 10, 11) à relier à l'élément extractible (2, 3), de préférence une prise électrique, et
- au moins un guide-câble (12), de préférence à relier à la glissière d'extraction (4), lequel est conçu pour guider au moins un câble électrique (13) vers le dispositif de prélèvement de courant (9, 10, 11),
**caractérisé en ce qu'**il est prévu au moins un dispositif de maintien (30, 31) conçu pour maintenir le dispositif de prélèvement de courant (9, 10, 11) au niveau de et/ou dans et/ou au-dessus d'une ouverture (28) pratiquée dans un fond (29) de l'élément extractible (2, 3) orienté horizontalement en position d'utilisation de l'élément extractible (2, 3), l'élément extractible (2, 3) étant relié, dans une position d'utilisation, de préférence sur un côté longitudinal (37), au rail de tiroir (7) dudit au moins une glissière d'extraction (4), l'élément extractible (2, 3) présentant au moins un fond (29) orienté horizontalement en position d'utilisation de l'élément extractible (2, 3) et dans lequel est formée au moins une ouverture (28), de préférence cylindrique, le dispositif de prélèvement de courant (9, 10, 11) étant maintenu au niveau de et/ou dans et/ou au-dessus de l'ouverture de fond (28) au moyen dudit au moins un dispositif de maintien (30, 31), le dispositif de maintien (30, 31) présentant au moins en partie la forme d'une fourche et entourant au moins en partie l'ouverture de fond (28) en position de montage.

2. Arrangement (36) selon la revendication 1, dans lequel le dispositif de maintien (30, 31) comprend au moins une bride de maintien à relier, de préférence à visser, à une face supérieure (55) du fond (29) de l'élément extractible (2, 3).

3. Arrangement (36) selon l'une des revendications 1 à 2, dans lequel le dispositif de prélèvement de courant (9, 10, 11) peut être relié au dispositif de maintien (30, 31) au moyen d'au moins une liaison encliquetable (58) et/ou d'au moins une liaison vissée (59), et/ou peut être enfilé sur le dispositif de maintien (30, 31).

4. Arrangement (36) selon l'une des revendications 1 à 3, dans lequel le dispositif de maintien (31) présente au moins une interface (60) pour la liaison avec au moins un autre dispositif de maintien (61) pour au moins un autre dispositif de prélèvement de courant (9, 10, 11).

5. Arrangement (36) selon l'une des revendications 1 à 4, dans lequel le dispositif de prélèvement de courant (9, 10, 11) présente au moins une interface (63), de préférence disposée sur une face latérale (62), pour le raccordement d'au moins un autre dispositif de prélèvement de courant (9, 10, 11), le dispositif de prélèvement de courant (9, 10, 11) et ledit au moins un autre dispositif de prélèvement de courant (9, 10, 11) se distinguant de préférence l'un de l'autre par une forme de logement de fiche électrique (64, 65, 66).

6. Arrangement (36) selon l'une des revendications 1 à 5, dans lequel le dispositif de prélèvement de courant (9, 10, 11) présente au moins une interface (75), disposée de préférence à proximité du fond (29) de l'élément extractible (2, 3) et/ou sur une face frontale (67), pour le montage d'une plaque de logo (68).

7. Arrangement (36) selon l'une des revendications 1 à 6, dans lequel la glissière d'extraction (4) ou l'élément extractible (2, 3) peut être relié, ou est relié, à au moins un dispositif d'entraînement (14) au moyen duquel le rail de tiroir (7) ou l'élément extractible (2, 3) destiné à y être relié peut être entraîné par rapport au rail de corps (6), et le dispositif d'alimentation électrique (1) comprend au moins un entraîneur (15), lequel peut être fixé de manière détachable à la glissière d'extraction (4) au moyen d'au moins une interface (16) et est conçu pour coopérer avec le dispositif d'entraînement (14) afin de transmettre une force du dispositif d'entraînement (14) à l'un des rails de la glissière d'extraction (4) ou à l'élément extractible (2, 3), le guide-câble (12) et l'entraîneur (15) formant une unité structurelle commune pouvant être fixée de manière détachable à la glissière d'extraction (4).

8. Arrangement (36) selon l'une des revendications 1 à 7, dans lequel il est prévu au moins un dispositif conducteur de courant (27) conçu pour être fixé au niveau de et/ou dans une ouverture (28) pratiquée dans un fond (29) de l'élément extractible (2, 3) orienté horizontalement en position d'utilisation dudit élément extractible (2, 3), et pour conduire le courant à travers l'ouverture de fond (28) vers le dispositif de prélèvement de courant (9, 10, 11).

9. Arrangement (36) selon la revendication 8, dans lequel ledit au moins un dispositif de maintien (30) est disposé, ou peut être disposé, sur le dispositif conducteur de courant (27), le dispositif de maintien (30) étant de préférence disposé mobile sur le dispositif conducteur de courant (27).

10. Arrangement (36) selon la revendication 8 ou 9, dans lequel le dispositif conducteur de courant (27) présente au moins un dispositif de connexion enfichable (57), au moyen duquel le dispositif de prélèvement de courant (9, 10, 11) peut être mis en contact électriquement conducteur avec le dispositif conducteur de courant (27), le dispositif de connexion enfichable (57), en position de montage du dispositif conducteur de courant (27), saillant de préférence hors de l'ouverture de fond (28) au-dessus de la face supérieure (55) du fond (29) de l'élément extractible (2, 3).

11. Arrangement (36) selon l'une des revendications 1 à 10, dans lequel le dispositif d'alimentation électrique (1) comprend en outre
- au moins un support de câble (32), lequel peut être relié de manière détachable et/ou frontalement au rail de corps (6), et/ou
- au moins une chaîne porte-câbles (33) conçue pour guider ledit au moins un câble électrique (13) dans un plan situé au-dessous de l'élément extractible (2, 3) lors d'un déplacement de l'élément extractible (2, 3) entre une position fermée et une position ouverte, et/ou
- au moins un dispositif de connexion enfichable (34) stationnaire, de préférence disposé sur le rail de corps (6), au moyen duquel le dispositif d'alimentation électrique (1) peut être relié à une source d'alimentation électrique stationnaire (35), et/ou
- au moins un dispositif de coupure comprenant au moins un capteur pour détecter une position fermée de la glissière d'extraction (4) ou de l'élément extractible (2, 3), et au moins un élément de commutation au moyen duquel l'alimentation électrique peut être interrompue en fonction d'un signal du capteur.

12. Arrangement (36) selon l'une des revendications 1 à 11, dans lequel ledit au moins un dispositif de prélèvement de courant (9, 10, 11) est disposé au moins en partie à l'intérieur de l'ouverture de fond (28), ou l'élément extractible (2, 3) présente au moins une paroi arrière (69) orientée sensiblement verticalement par rapport au fond (29), et ledit au moins un dispositif de prélèvement de courant (9, 10, 11) est disposé au-dessus de l'ouverture de fond (28), dans un plan parallèle à la paroi arrière (69) et à l'extérieur de la paroi arrière (69).

13. Procédé pour le montage d'au moins un arrangement (36) selon l'une des revendications 1 à 12 sur au moins un corps de meuble (5), le procédé comprenant les étapes de procédé suivantes, de préférence dans l'ordre chronologique indiqué :
- ladite au moins une glissière d'extraction (4) est montée sur le corps de meuble (5) au moyen du rail de corps (6),
- ledit au moins un dispositif de prélèvement de courant (9, 10, 11) est relié à l'élément extractible (2, 3) au moyen dudit au moins un dispositif de maintien (30, 31), au niveau de et/ou dans et/ou au-dessus de l'ouverture de fond (28), et
- ledit au moins un élément extractible (2, 3) est relié au rail de tiroir (7) de la glissière d'extraction (4).
